Europäisches Patentamt

European Patent Office

Office européen des brevets

(19)

(11) Veröffentlichungsnummer: **0 141 984**
**B1**

(12) **EUROPÄISCHE PATENTSCHRIFT**

(45) Veröffentlichungstag der Patentschrift: **02.01.91**

(21) Anmeldenummer: **84111431.7**

(22) Anmeldetag: **25.09.84**

(51) Int. Cl.⁵: **H 04 Q 3/545,** G 06 F 15/16,
G 06 F 11/00

(54) Multiprozessor-Zentralsteuereinheit eines Vermittlungssystems insbesondere Fernsprech-Vermittlungssystems.

(30) Priorität: **26.09.83 DE 3334766**

(43) Veröffentlichungstag der Anmeldung:
**22.05.85 Patentblatt 85/21**

(45) Bekanntmachung des Hinweises auf die
Patenterteilung:
**02.01.91 Patentblatt 91/01**

(84) Benannte Vertragsstaaten:
**AT BE CH DE FR GB IT LI NL SE**

(56) Entgegenhaltungen:
DE-A-3 334 766
US-A-4 115 866

ERICSSON REVIEW, Band 54, Nr. 2, 1977, Seiten 77-85, Stockholm, SE; A. HEMRE et al.: "The software and its handling in ARE systems"

INTERNATIONAL SWITCHING SYMPOSIUM, 25.-29. Oktober 1976, "paper 412-3", Seiten 1-8, Kyoto, JP; Z. KOONO et al.: "A distributed control system for electronic switching systems"

(73) Patentinhaber: **Siemens Aktiengesellschaft
Wittelsbacherplatz 2
D-8000 München 2 (DE)**

(72) Erfinder: **Bitzinger, Rudolf, Dipl.-Ing.
Lechbrucker Strasse 11
D-8000 München 71 (DE)**
Erfinder: **Engl, Walter, Dipl.-Ing.
Am Kellerberg 4
D-8152 Feldkirchen-W. (DE)**
Erfinder: **Humml, Siegfried
An der Freiheit 130
D-8122 Penzberg (DE)**
Erfinder: **Schreier, Klaus, Dipl.-Ing.
Nonnenwaldstrasse 8a
D-8122 Penzberg (DE)**

(56) Entgegenhaltungen:
HET PTT-BEDRIJF, Band XVIII, Nr. 4, Dezember 1973, Seiten 283-286, Den Haag, NL; S. SUNDSTRÖM: "AKE 13 - further development"

COMMUTATION ET ELECTRONIQUE, Nr. 51, October 1975, Seiten 55-66, Issy-les-Moulineaux, FR; P. COLLET et al.: "Le traducteur à programme enregistré"

# EP 0 141 984 B1

(56) Entgegenhaltungen:
ELECTRONIC DESIGN, Band 24, Nr. 12, 7. Juni
1976, Seiten 132-136, Rochelle Park, US; D.
CHUNG: "Multiprocessor control systems"

SIXTH EUROMICRO SYMPOSIUM ON
MICROPROCESSING AND
MICROPROGRAMMING, London, 16.-18.
September 1980, Seiten 101-106, North-Holland
Publishing Co., Amsterdam, NL; M. CICCOTTI et
al.: "EMMET: the kernel of the multimicroprocessor operating system for a small
local exchange"

PROCEEDINGS OF THE NATIONAL
ELECTRONICS CONFERENCE, Band 29, Nr. 29,
Oktober 1974, Seiten 53-54, New York, US; M.
WARD: "The GEC MkII multiprocessor control
for telecommunications systems"

**Beschreibung**

Die Erfindung geht von der im Oberbegriff des Patentanspruchs 1 genannten Multiprozessor-Zentralsteuereinheit aus.

Zentralsteuereinheiten gemäß dem Oberbegriff des Patentanspruchs 1, welche also aus einer höheren Vielzahl von Prozessoren bzw. Rechnern—welche keine eigenen lokalen Speicher oder welche eigene lokale Speicher haben—mit Hilfe eines allen Prozessoren beziehungsweise Rechnern gemeinsamen Bussystems gebildet werden, sind für sich seit Jahren in der Diskussion, in verschiedener Weise entwickelt und, jedenfalls zum Teil, zumindest versuchsweise realisiert. Sie können insbesondere für ein besonders großes Fernsprech-Vermittlungssystem verwendet werden, bei denen die einzelnen, für 1 Verbindung jeweils nötigen Bearbeitungsschritte zwar kurz, oft nur wenige Takte lang dauern, bei denen aber häufig eine hohe Vielzahl von vermittlungstechnischen Funktionen simultan bzw. quasisimultan für die vielen gleichzeitigen Verbindungen durchzuführen sind, wie z.B. die Überwachung des Teilnehmers auf Abheben und Rufnummernwahl, Wegesuche, Wegedurchschaltung, Signaltöne, Gebührenerfassung, Ansagen, Facilities verschiedenster Art, usw. Solche Zentralsteuereinheiten müssen also eine hohe Verarbeitungskapazität sowie eine extrem hohe Verfügbarkeit, also möglichst nur Minuten oder Sekunden Totalausfallzeit pro Jahr, aufweisen. Sowohl hohe Verarbeitungskapazitäten, hohe Verfügbarkeit als auch Einsparungen beim Hardwareaufwand sind für sich bekannte Aufgaben von derartigen Multiprozessor-Zentralsteuereinheiten Bussysteme, welche den verschiedenen Prozessoren einen wahlweisen Zugriff auf den daran angeschlossenen Hauptspeicher mittels Arbitern ermöglichen, sind für sich in verschiedenen Varianten bekannt. Darunter gibt es auch außerordentlich komfortable, vielseitige, außerordentlich sichere Bussysteme mit gedoppelten Bussen und mit hoher Verfügbarkeit.

Im Hinblick auf eine Verringerung der Gesamtdauer der Belegung des Hauptspeichers durch die Zugriffe eines Prozessors und auf die Möglichkeit einer möglichst gleichmäßigen Lastverteilung auf die einzelnen Prozessoren, was wiederum die Voraussetzung der Bewältigung einer relativ großen Gesamtlast ist, enthalten bei einer Multiprozessor-Zentralsteuereinheit der im Oberbegriff des Patentanspruchs angegebenen Art die lokalen Speicher aller Prozessoren, welche zumindest weitgehend denselben Katalog von Aufgaben-Bearbeitungsschritten zu steuern haben, ständig entsprechend identische Programmabschnitte, bei denen es sich um diejenigen handelt, die am häufigsten und/oder bei Störungen am dringendsten benötigt werden, wogenen der Hauptspeicher neben seltener benötigten Programmabschnitten noch Daten über eine große Vielzahl von derzeitigen Verbindungen speichert (siehe hierzu US—A—4 115 866; Ericsson Review, Band 54, Nr. 2, 1977, Seiten 77 bis 85; International Switching Symposium, 25. bis 29. Oktober 1976, "paper 412—3", Seiten 1 bis 8, HET PITT-BEDRIJF, Band XVIII, Nr. 4, Dezember 1973, Seiten 283 bis 286).

Die Aufgabe der Erfindung besteht darin, bei einer solchen Multiprozessor-Zentralsteuereinheit sicherzustellen, daß durch den Ausfall eines einzigen Prozessors die Störung des Gesamtbetriebs möglichst gering ist.

Diese Aufgabe wird durch die im Kennzeichen des Patentanspruchs genannten Maßnahmen gelöst.

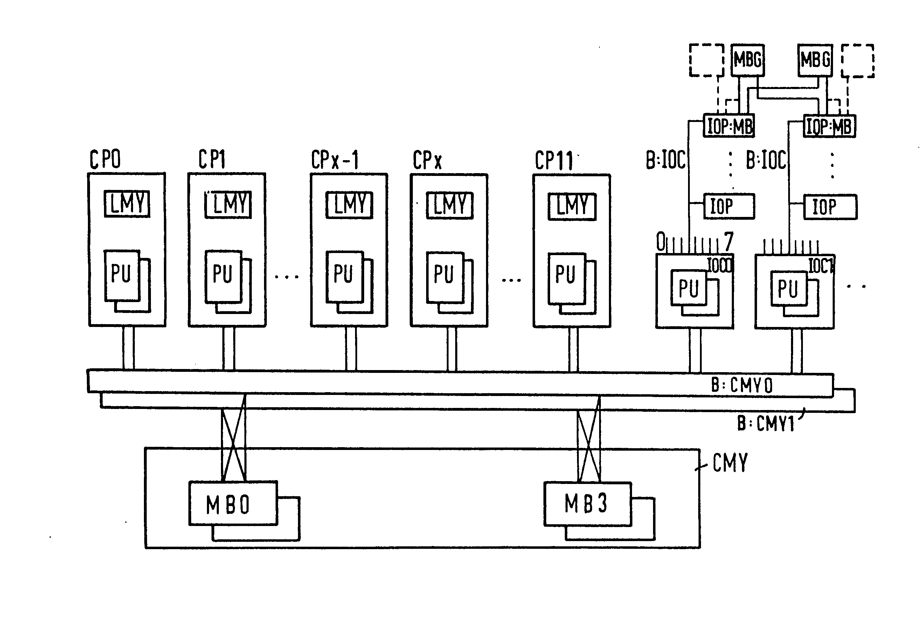

Die Erfindung wird anhand eines Ausführungsbeispiels näher erläutert, welches in der Figur gezeigt ist.

Die Figur zeigt eine Zentralsteuereinheit, bei der z.B. zwölf Prozessoren CP, sowie mehrere Prozessoren IOC über das Bussystem B:CMY mit dem Hauptspeicher CMY zusammenarbeiten. Aus Sicherheitsgründen ist das Bus-system gedoppelt, vgl. B:CMY0 und B:CYM1, evtl. auch die Prozessoren CP/IOC.

Die-bevorzugt im wesentlichen untereinander gleichaufgebauten—Prozessoren CP führen, zumindest wenn genügend Verbindungsanorderungen vorliegen, simultan jeweils vermittlungstechnische, sicherungstechnische und/oder betriebstechnische Funktionen aus. Jeder Prozessor CP enthält neben der eigentlichen, übrigens ebenfalls gedoppelten Prozessoreinheit PU jeweils den prozessorindividuellen lokalen Speicher LMY besonders für Daten, welche er zur Bearbeitung einer speziellen vermittlungstechnischen Funktion für 1 Verbindung zwischen zwei beliebigen Vermittlungssystemteilnehmern benötigt. Diese Daten können hierzu zuvor aus dem Hauptspeicher CMY abgerufen worden sein. Ferner enthalten die lokalen Speicher LMY die vom Prozessor am häufigsten/dringendsten benötigten Programmabschnitte. Da viele der Prozessoren einen identischen öder weitgehend identischen Katalog von Aufgaben zu bearbeiten haben, z.B. alle evtl. vorkommenden vermittlungstechnischen Aufgaben selbständig lösen können müssen, speichern deren lokale Speicher LMY—zumindest teilweise—identische Programmabschnitte. Bevorzugt speichert sie hierbei jeweils auch jene Programmabschnitte, welche im Störungsfall zum Anlaufen und zur Fehlererkennung vom betreffenden Prozessor benötigt werden, so daß in solchen Störungsfällen nicht erste zeitraubende Zugriffe auf den Hauptspeicher CMY nötig sind.

Die Prozessoren IOC haben acht besondere Ausgänge 0 bis 7 mit Bussen B:IOC, über die sie mit IO-Units IOP und peripheren Einheiten MBG des Fernsprech-Vermittlungssystems, z.B. mit Leitungsgruppensteuerungen, Tongeneratoren, Gebührenzählern usw., kommunizieren.

Bei dem in der Figur gezeigten Beispiel ist der an das Bussystem B:CMY angeschlossene Hauptspeicher CMY aus vier verschiedenen, überdies in sich jeweils aus Sicherheitsgründen gedoppelten Speicherbanken MB0...MB3 aufgebaut. Sie speichern die wichtigsten Daten über alle Verbindungen des Vermittlungssystems, sowie die seltener benötigten, sowie die—auch in Störungsfällen—von den Prozessoren nicht mehr dringend/sofort benötigten Programmabschnitte. Im Prinzip können alle Prozessoren CP/IOC über das Bussystem B:CMY Zugriff auf alle Daten des Hauptspeichers CMY bzw. auf alle Daten der Speicherbanken MB haben, soweit nicht—z.B. durch Beschränkung der Adressen—die Bereichtigung des Zugriffs eingeschränkt wird.

Die Figur zeigt ferner periphere Einheiten MBG des Fernsprech-Vermittlungssystems, welche mittelbar oder unmittelbar auf die Leitungen des Vermittlungsnetzwerkes einwirken, z.B. im Rahmen der Wegesuche, Durchschaltung, Signalisierung, usw.. Diese peripheren Einheiten MBG sind hier gedoppelt, vgl. die Auskreuzungen der Leitungen. Sie besitzen im gezeigten Beispiel eigene IO-Units, vgl. IOP:MB. Es sind weiter solche IO-Units an die lokalen Busse B:IOC angeschlossen, vgl. IOP, welche jeweils zwar mit weiteren solchen peripheren Einheiten verbunden sind, die aber der Übersichtlichkeit wegen in der Figur nicht mehr gezeigt sind.

Diese IO-Units IOP:MB...IOP bzw. deren lokale Busse B:IOC sind über IO-Prozessoren IOC, vgl. IOC0, IOC1, mit dem Bussystem B-CMY verbunden. Diese IO-Prozessoren IOC können vor allem zur Anpassung an den Katalog der Bedingungen des Bussystems B:CMY dienen. Durch Punkte wurde in der Figur angedeutet, daß noch weitere solche IO-Prozessoren IOC, insbesondere bei sehr großen Vermittlungssystemen, vorgesehen sein können.

Die peripheren Einheiten, vgl. MBG. sind jeweils mit verschiedenen der Prozessoren CP, von Fall zu Fall anders verteilt, verbindbar und/oder auch mit dem Hauptspeicher CMY, bzw. mit Teilen von dessen Speicherbanken MB, verbindbar. Durch diese Verbindungen können Meldungen und/oder Anfragen von peripheren Einheiten MBG, und Meldungen und/oder Anfragen zu solchen peripheren Einheiten MBG hin, durchgeführt werden. Die vermittlungstechnischen Meldungen und/oder Anfragen einer peripheren Einheit MBG werden dabei bevorzugt autonom über das mit ihnen verbundene IO-Unit IOP per Ruf verteilt, indem das jeweils betreffende IO-Unit IOP, wenn es einen Ruf von der peripheren Einheit MBG erhält, dieser rufenden peripheren Einheit MBG einen der Prozessoren CP, bzw. einen Teil des Hauptspeichers CMY bzw. MB, zuteilt bzw. über das Bussystem B:CMY zuteilen läßt. Diese Zuteilung eines speziellen Prozessors und/oder eines speziellen Teils des Hauptspeichers CMY/MB an die z.B. zwei peripheren Einheiten MBG (1 Verbindung belegt z.B. zwei MBGs) wird dann noch in einem Datenfeld abgespeichert, wobei dieses Datenfeld auch innerhalb einer Speicherbank MB des Hauptspeichers CMY angebracht sein kann. Durch diese Abspeicherungen im Datenfeld sind, insbesondere unter Mitwirkung der jeweils betroffenen IO-Unit IOP der betroffenen peripheren Einheiten MBG, alle späteren Meldungen oder Anfragen der betroffenen peripheren Einheiten MBG, welche diesem Ruf nachfolgen, jeweils zum selben, vorher zugeteilten Prozessor CP bzw. zum selben Hauptspeicherteil MB sendbar, damit dort die betreffenden vermittlungstechnischen Funktionen und/oder Registrierungen, welche durch den Ruf ausgelöst werden, fortgesetzt werden können. Eine solche autonome Zuteilung per Ruf ermöglicht eine angenähert gleichmäßige Belastung aller Prozessoren CP mit vermittlungstechnischen Funktionen—zumindest kann diese Zuteilung dann jeweils entsprechend der momentanen Auslastung der betreffenden Prozessoren CP so gesteuert werden, daß die dem Ruf folgenden Meldungen und/oder Anfragen wirklich jeweils rasch von einem der Prozessoren, der noch eine ausreichend freie Kapazität hat, bearbeitet werden können.

Der Aufbau der einzelnen Organe dieser Multiprozessor-Zentralsteuereinheit—z.B. der Prozessoren CP, der Speicherbanken MB bzw. des Hauptspeichers CMY, der IO-Prozessoren IOC welche z.B. auch eine verschiedene Anzahl von lokalen Systembussen B:IOC (vgl. die Ausgänge 0...7 des IO-Prozessors IOC0) haben können—kann jeweils an sich beliebig sein. Sie müssen nur zur Schnittstelle des gewählten Bussystems B:CMY passen bzw. an dessen Aufbau bzw. Betriebsweise angepaßt werden.

Die peripheren Einheiten können ebenfalls an sich einen beliebigen Aufbau mit beliebigen Funktionen aufweisen. Sie können sowohl gerätetechnische Organe darstellen als auch vermittlungstechnische Teilfunktionen von peripheren Organen, welche einen größeren Komplex verschiedener Funktionen ausführen. Trotz der forderbaren hohen Verfügbarkeit genügt es im allgemeinen, diese peripheren Organe über ungedoppelte, also einfach vorhandene IO-Units IOP:MB...IOP an die IO-Prozessoren IOC anzuschließen, wenn diese peripheren Organe, vgl. MBG, für sich über Auskreuzungen angeschlossen sind, vgl, die Figur. Diese IO-Units IOP und/oder die zugehörigen IO-Prozessoren IOC können für sich zusätzliche Prüfungsfunktionen aufweisen, um unkontrollierte Zugriffe zu den Prozessoren CP und zum Hauptspeicher CMY/MB, welche auf Fehlern beruhen, zu erschweren.

Bei einem derzeit entwickleten Beispiel gem. der Figur wurden für die Prozessoren CP jeweils SAB 80286-Mikroprozessoren verwendet, die jeweils über einen physikalischen Adressraum von 16 MByte verfügen. Für die Prozessoren IOC wurden jeweils 8086-Bausteine verwendet. Die Prozessoren wurden zur Verbesserung der Fehlererkennung bevorzugt gedoppelt, sie wurden parallel betrieben und waren dann jeweils nur paarweise abschaltbar.

Bei einem solchen Ausfall eines Prozessors bzw. Prozessorpaares CP werden alle Verbindungen gefährdet oder gestört, die derzeit von ihm bearbeitet werden. In ihrem lokalen, prozessorindividuellen Speicher LMY sind jeweils die für ihre dynamische Funktion wichtigsten Programmabschnitte und die für ihren derzeiten Bearbeitungsschritt wichtigen lokalen Daten gespeichert. Um Gefährungen bzw. Störungen möglich klein zu machen, speicher erfindungsgemäß der lokale Speicher LMY des betreffenden Prozessors CP, welcher den betreffenden derzeitigen Bearbeitungsschritt jeweils für eine Verbindung steuert, im allgemeinen oder immer, nur solche Daten, welche speziell für 1 Verbindung zweier beliebiger Vermittlungssystemteilnehmer zu dem derzeitigen Bearbeitungsschritt, z.B. zur Wegesuche, nötig sind; wobei aber der Hauptspeicher CMY die Daten über eine große Vielzahl von derzeitigen Verbindungen speichert. Der lokale Speicher LMY speicher also—zur Durchführung aller auf spezielle Verbindungen von Vermittlungssystemteilnehmern bezogenen vermittlungstechnischen Funktionen, z.B. Wegesuche, Durchschaltung, Gebührenerfassung, Hörtönesteuerung, Rufnummernanahme und -umcodierung, Verbindungswegabbau, usw.—jeweils nur die nötigen Daten für 1 Verbindung, die er gerade bearbeitet. Fällt der betreffende Prozessor CP wirklich aus, dann wird höchstens diese 1 Verbindung, die er soeben bearbeitet, gestört, aber nicht alle übrigen. Bei der Verteilung der Arbeiten auf die verschiedenen Prozessoren CP mit eigenen lokalen Speichern LMY kann dann der betreffende ausgefallene Prozessor CP solange übersprungen werden, bis für ihn ein Ersatz geschaffen oder er in Ordung gebracht wurde.

Falls man zusätzlich die in den lokalen Speichern LMY gespeicherten Daten auch noch im Hauptspeicher CMY abspeichert, kann man im Prinzip sogar diese Daten bei einem solchen Ausfall aus dem Hauptspeicher CMY wieder in den lokalen Speicher LMY eines anderen Prozessors CP einschreiben, wodurch, jedenfalls häufig, die betreffende bearbeitete Verbindung, trotz des Ausfalls, nachträglich noch bearbeitet werden kann.

**Patentanspruch**

Multiprozessor-Zentralsteuereinheit eines Vermittlungssystems, insbesondere Fernsprech-Vermittlungssystems mit
—einem Bussystem (PB:CMY), an welchem die einen eigenen lokalen Speicher (LMY) aufweisenden Prozessoren (CP, IOC) angeschlossen sind und welches nacheinander verschiedenen der Prozessoren (z.B. CP1, CPx, IOC0) zugeteilt wird, und
—einem an dessen Bussystem (B:CMY) angeschlossenen Hauptspeicher (CMY), zu welchem die Prozessoren (CP, IOC) über dus Bussystem (B:CMY) nacheinander, entsprechend den Zuteilungen des Bussystems (B:CMY), Zugriff haben, bei welchem,
—zur Durchführung aller auf spezielle Verbindungen von Vermittlungssystemteilnehmern bezogenen vermittlungstechnischen Funktionen, z.B. Wegesuche, Durchschaltung, Gebührenerfassung, Hörtönesteuerung, Rufnummernaufanahme und -Umcodierung, Verbindungswegabbau,
—die lokalen Speicher (LMY) aller Prozessoren (CP), welche zumindest weitgehend denselben Katalog von Aufgaben-Bearbeitungsschritten zu steuern haben, ständig entsprechend identische, nämlich die am häufigsten, und/oder bei Störungen am dringendsten, von diesen Prozessen (CP, IOC) benötigten Programmschritte speichern, aber der Hauptspeicher (CMY), neben seltener benötigten Programmabschnitten, noch Daten über eine große Vielzahl von derzeitigen Verbindungen speichert, dadurch gekennzeichnet,

daß die lokalen Speicher (LMY) zusätzlich zeitweise noch solche nichtidentischen Daten speichern, welche speziell für eine einzige Verbindung zweier beliebiger Vermittlungssystemteilnehmer zu dem derzeitigen Bearbeitungsschritt, z.B. zur Wegesuche, erforderlich sind.

**Revendication**

Unité de commande centrale à processeurs multiples pour un système de commutation, notamment un système de commutation téléphonique, comportant
—un système de bus (B:CMY), auquel sont raccordés les processeurs (CP, IOC) possédant une mémoire locale propre (LMY) et qui est affecté successivement à différents processeurs (par exemple CP1, CPx, IOC0) et
—une mémoire principale (CMY), qui est raccordée à son système de bus (B:CMY) et à laquelle les processeurs (CP, IOC) ont accès successivement, par l'intermédiaire du systéme de bus (B:CMY), en fonction des affectations de ce dernier, et dans lequel
—pour l'exécution de toutes les fonctions techniques de commutation associées à des liaisons particulières d'abonnés du système de commutation, par exemple la recherche de voies d'acheminement, l'interconnexion directe, la détermination de taxes, la commande de tonalités, la réception et le transcodage de numéros d'appel, la suppression de voies d'acheminement de liaisons,
—les mémoires locales (LMY) de tous les processeurs (CP), qui doivent commander au moins dans une large mesure le même ensemble de pas d'éxecution de tâches, mémorisent en permanence des pas de programme identiques correspondants, c'est-à-dire des pas de programme qui sont requis par ces processeurs (CP, IOC) le plus fréquemment et/ou de la mamière la plus urgente dans le cas de perturbations, mais également la mémoire principale (CMY) mémorise non seulement des pas de programme nécessaires plus rarement, mais également des données concernant un nombre important de liaisons actuelles, caractérisé par le fait

que les mémoires locales (LMY) mémorisent en outre par instants également des données non identiques, qui sont nécessaires en particulier pour une liaison unique entre deux abonnés quelconques du système de commutation, pour le même pas de traitement actuel, par exemple pour la recherche d'une voie d'acheminement.

## Claim

Multiprocessor central control unit of a switching system, in particular telephone exchange system, having

—a bus system (B:CMY) to which the processors (CP, IOC) having their own local memories (LMY) are connected, and which is successively allocated to different processors (e.g. CP1, CPx, IOC0), and

—a main memory (CMY) connected to the bus system (B:CMY) thereof, to which memory the processors (CP, IOC) successively have access via the bus system (B:CMY) in accordance with the allocations of the bus system (B:CMY), in which

—for carrying out all the switching functions related to special connections of exchange system subscribers, for example routing, through-connection, charge recording, call progress tone control, call number acceptance and recoding, connection clearing,

—the local memories (LMY) of all the processors (CP) which have to control at least to a large extent the same range of task processing steps continuously store correspondingly identical program steps, namely the ones required most frequently, and/or most urgently in the case of malfunctions, by these processors (CP, IOC), but the main memory (CMY) also stores, besides program sections required less frequently, data relating to a large number of current connections,

characterized in that the local memories (LMY) additionally store from time to time also such non-identical data which are required specially for a single connection between any two exchange system subscribers for the current processing step, for example for routing.

CP0  CP1  CPx-1  CPx  CP11

LMY  LMY  LMY  LMY  LMY

PU  PU  ...  PU  PU  ...  PU

MBG  MBG

IOP:MB  IOP:MB

B:IOC  :  B:IOC  :

IOP  IOP

0 | | | | | | | 7

PU IOC0  PU IOC1  · ·

B:CMY0

B:CMY1

CMY

MB0  MB3

EP 0 141 984 B1